(19) Europäisches Patentamt
European Patent Office
Office européen des brevets

(11) **EP 1 076 355 A2**

(12) **EUROPEAN PATENT APPLICATION**

(43) Date of publication:
**14.02.2001 Bulletin 2001/07**

(51) Int Cl.⁷: **H01L 21/00**

(21) Application number: **00306846.7**

(22) Date of filing: **10.08.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **12.08.1999 US 373103**

(71) Applicant: **Applied Materials, Inc.**
**Santa Clara, California 95054 (US)**

(72) Inventors:
• **Pavate, Vikram**
**San Jose, California 95126 (US)**

• **Sung, Bing XI**
**Stanford, California 94305 (US)**
• **Ding, Peijum**
**San Jose, California 95129 (US)**
• **Hong, Ilyoung R.**
**San Jose, California 95136 (US)**
• **Chin, Barryl L.**
**Saratoga, California 95070 (US)**

(74) Representative: **Bayliss, Geoffrey Cyril et al**
**BOULT WADE TENNANT,**
**Verulam Gardens**
**70 Gray's Inn Road**
**London WC1X 8BT (GB)**

(54) **Method and apparatus for cleaning a chamber configured for copper deposition**

(57)  A method and apparatus for reducing the pump down time of a chamber configured for copper deposition are provided. Hydrogen and a carrier gas are introduced into the chamber, a plasma is ignited and the chamber is cleaned with the plasma. Preferably the carrier gas comprises a non-reactive gas such as semiconductor grade argon, helium or nitrogen. The hydrogen preferably is diluted to about 5%, and the hydrogen and carrier gas may be provided from a single source by diluting the hydrogen via the carrier gas. To improve cleaning effectiveness, the chamber shield and/or target may be heated during cleaning. If the chamber configured for copper deposition is a high density plasma chamber, the chamber's copper coil also may be heated during cleaning.

FIG. 1.

**Description**

The present invention relates generally to metal film deposition and more particularly to a method and apparatus for cleaning a chamber configured for copper deposition.

Metal films are used widely within semiconductor integrated circuits to make contact to and between semiconductor devices (i.e., metal interconnects). Because of the high densities required for modern integrated circuits, the lateral dimensions of interconnects, as well as the lateral dimensions between interconnects, have shrunk to such a level that a single defect can destroy an entire wafer die by shorting a junction region or open-circuiting a gate electrode of an essential semiconductor device. Defect reduction within interconnect metal films, therefore, is an ever-present goal of the semiconductor industry that increases in importance with each generation of higher density integrated circuits.

Interconnect metal films typically are deposited via physical vapor deposition within a plasma chamber, and more recently via high density plasma (HDP) deposition. In both processes, a target of to-be-deposited material (e.g., the metal comprising the interconnect) is sputtered through energetic ion bombardment that dislodges atoms from the target. The dislodged atoms travel to a wafer disposed below the target and form a metal film thereon. The metal film is patterned to form the interconnect.

The use of copper in place of aluminum as the interconnect material for semiconductor devices has grown in popularity due to copper's lower resistivity. However, unlike other sputtered metals, copper does not form a self-terminating oxide (e.g., a copper target and any copper parts within a chamber configured for copper deposition will continuously oxidize if exposed to oxygen), and readily oxidizes when exposed to oxygen. Exposure to oxygen can occur when a copper target is first installed within a deposition chamber, during preventative maintenance of a deposition chamber such as during the cleaning of a clamp ring or shield and even during chamber idle due to the residual oxygen background present within all deposition chambers.

Copper films formed from an oxidized copper target have poor surface roughness characteristics and high sheet resistance due to the inclusion of copper-oxide within the sputtered copper films. This is particularly true for the first semiconductor wafer processed after chamber idle or maintenance (i.e., the first wafer effect). Further, the use of an oxidized copper target can result in significant arc-induced defects (e.g., splats) in deposited copper films as described in commonly assigned U. S. Patent Application Serial No. 09/272,974, filed March 18, 1999 which is hereby incorporated by reference herein in its entirety. As compared to other metal oxides produced during semiconductor manufacture copper oxide also exhibits poor pump down times. Specifically, the poor gettering properties of copper oxides produce long pump down times and high base pressures for copper deposition chambers. Accordingly, prior to deposition, copper oxides should be cleaned from all copper surfaces within a chamber configured for copper deposition.

A conventional technique for removing copper oxides from chamber surfaces is to expose the chamber surfaces to an argon plasma, and to generate a negative potential on the copper chamber surfaces to be cleaned. Positive argon ions thereby accelerate toward the copper chamber surfaces and remove copper oxide therefrom due to momentum transfer (e.g., physical sputtering).

Conventional argon sputtering alone is inefficient at removing copper oxides. Long target burn-in times are still required to remove residual copper oxide from copper target surfaces prior to deposition. Argon sputtering also does not effectively clean copper oxide from all chamber surfaces (e.g., from copper coils, and support structures in an HDP chamber configured for copper deposition).

Accordingly, a need exists for an improved method and apparatus for cleaning a chamber configured for copper deposition.

To overcome the needs of the prior art, an improved method and apparatus for reducing the pump down time of a chamber configured for copper deposition are provided. Hydrogen and a carrier gas (e.g., semiconductor grade process gasses) are introduced into the chamber, a plasma is ignited and the chamber is cleaned with the plasma (including oxidized copper surfaces thereon). Preferably the carrier gas comprises a non-reactive gas such as semiconductor grade argon, helium or nitrogen, and for safety reasons, the hydrogen preferably is diluted to about 5%. For example, the hydrogen and carrier gas may be provided from a single source comprising about 5% hydrogen and 95% carrier gas.

The cleaning of copper oxide from copper surfaces within the chamber occurs via the reaction of hydrogen plasma species (e.g., atomic hydrogen, ionic hydrogen, etc.) with copper oxide so as to form water vapor. Water vapor formed during cleaning is exhausted from the chamber by a vacuum pump. To improve cleaning effectiveness, the target may be heated during cleaning. If the chamber configured for copper deposition includes other sources of copper such as a high density plasma chamber wherein a coil is placed internally of the chamber, the chamber's copper coil also may be heated during cleaning. The chamber shield is grounded or is left floating during cleaning.

Because of the efficiency with which the inventive method removes copper oxide from targets and coils, chambers in which the inventive method is performed exhibit lower base pressures and faster pump down times, and the copper films deposited therein exhibit reduced defect densities (e.g., few splats), more uniform and lower sheet resistances, and wafer throughput is increased. The first wafer effect is also reduced/eliminated.

Other objects, features and advantages of the present invention will become more fully apparent from the following detailed description of the preferred embodiments, the appended claims and the accompanying drawings; in which:

FIG. 1 is a side diagrammatic illustration, in section, of the pertinent portions of a high density plasma sputtering chamber configured in accordance with the present invention;

FIG. 2 is a flowchart of an inventive method for cleaning a chamber configured for copper deposition described with reference to the high density plasma chamber of FIG. 1; and

FIG. 3 is a top plan view of an automated semiconductor manufacturing tool employing the inventive high density plasma sputtering chamber of FIG. 1.

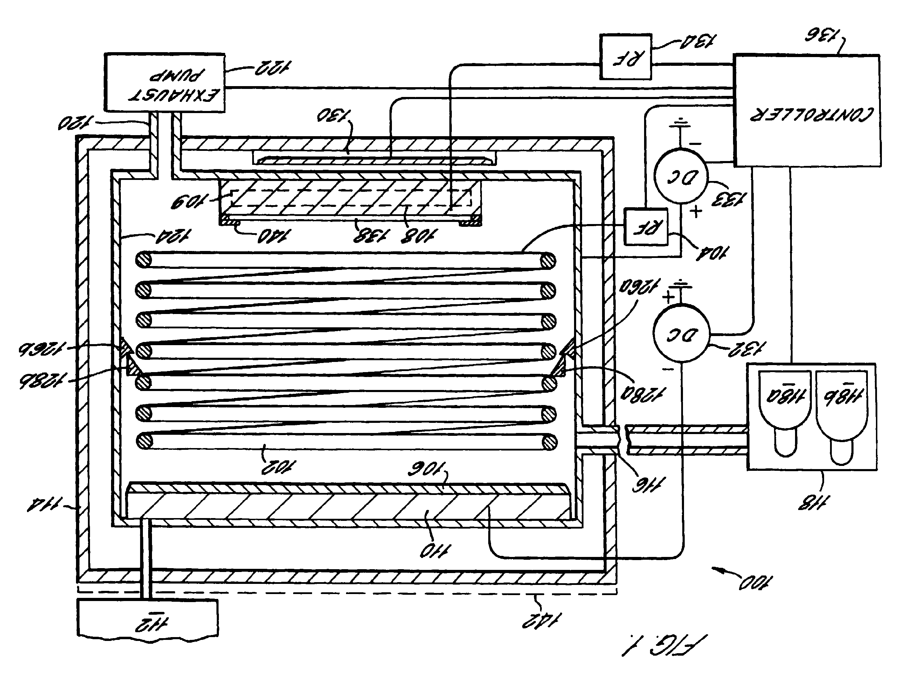

FIG. 1 is a side diagrammatic illustration, in section, of the pertinent portions of a conventional high density plasma sputtering chamber 100 configured in accordance with the present invention. The sputtering chamber 100 contains a wire coil 102 which is operatively coupled to a first RF power supply 104. The wire coil 102 may comprise a plurality of coils, a single turn coil as shown in FIG. 1, a single turn material strip for example having a height on the order of one inch, or any other similar configuration. The wire coil 102 is positioned along the inner surface of the sputtering chamber 100, between a sputtering target 106 and a wafer pedestal 108. The wafer pedestal 108 is positioned in the lower portion of the sputtering chamber 100 and typically comprises a pedestal heater 109 for elevating the temperature of a semiconductor wafer supported by the wafer pedestal 108 during processing within the sputtering chamber 100. The sputtering target 106 is mounted to a water cooled adapter 110 in the upper portion of the sputtering chamber 100 so as to face the substrate receiving surface of the wafer pedestal 108. A cooling system 110a is coupled to the adapter 110 and delivers cooling fluid (e.g., water) thereto.

The sputtering chamber 100 generally includes a vacuum chamber enclosure wall 114 having at least one gas inlet 116 coupled to a gas source 118 and having an exhaust outlet 120 coupled to an exhaust pump 39 (e.g., a cryopump or a cryoturbo pump). The gas source 118 comprises at least a source of semiconductor grade hydrogen 118a and a source of semiconductor grade carrier gas 118b such as a source of argon, helium or nitrogen. Any other non-reactive gas may be employed as a carrier gas. A removable shield 124 that surrounds the wire coil 102, the target 106 and the wafer pedestal 108 is provided within the sputtering chamber 100. The shield 124 may be removed for cleaning during chamber maintenance, and the adapter 110 is coupled to the shield 124 (as shown). The shield 124 also supports the wire coil 102 via a plurality of cups 126a-e attached to, but electrically isolated from the shield 124, and via a plurality of pins 128a-e (also electrically isolated from the shield 124) coupled to both the cups 126a-e and the wire coil 102. The wire coil 102 is supported by resting the wire coil 102 on the pins 128a-e which are coupled to the cups 126a-e. Any other known methods for supporting the wire coil 102 may be similarly employed. For copper deposition, the coil 102, the target 106, the cups 126a-e and the pins 128a-e all comprise high purity copper. The sputtering chamber 100 also includes a plurality of bake-out lamps 130 located between the shield 124 and the chamber enclosure wall 114, for baking-out the sputtering chamber 100 by heating it to a high temperature as is known in the art.

The sputtering target 106 and the wafer pedestal 108 are electrically isolated from the shield 124. The shield 124 may be grounded so that a negative voltage (with respect to grounded shield 124) may be applied to the sputtering target 106 via a first DC power supply 132 coupled between the target 106 and ground, or may be floated or biased via a second DC power supply 133 coupled to the shield 124. Additionally, a negative bias may be applied to the wafer pedestal 108 via a second RF power supply 134 operatively coupled between the pedestal 108 and ground. A controller 136 is operatively coupled to the first RF power supply 104, the first DC power supply 132, the second DC power supply 133, the second RF power supply 134, the gas source 118 and the exhaust pump 122.

To perform copper deposition within the sputtering chamber 100, a substrate 138 is loaded into the sputtering chamber 100, is placed on the wafer pedestal 108 and is securely held thereto via a clamp ring 140. An inert gas such as argon then is flowed from the gas source 118 into the high density plasma sputtering chamber 100 and the first DC power supply 132 biases the sputtering target 106 negatively with respect to the wafer pedestal 108 and the shield 124. In response to the negative bias, argon gas atoms ionize and form a plasma within the high density plasma sputtering chamber 100. An RF bias preferably is applied to the wire coil 102 via the first RF power supply 104 to increase the density, i.e., relative percentage of, ionized argon gas atoms within the plasma, and to ionize a significant number of the atoms sputtered from the target.

Because argon ions have a positive charge, argon ions from the plasma are attracted to the negatively biased sputtering target 106 and strike the sputtering target 106 with sufficient energy to sputter target material from the target 106. Likewise as the AC biased coil establishes a negative self bias, argon atoms are attracted thereto with significant energy to sputter material therefrom. The sputtered target material travels to and is deposited on the substrate 138 so as to form, over time, a continuous copper film thereon. A copper film also forms on the chamber components such as the shield 124, the clamp ring 140, etc. (forming a "copper coating" on the shield 124, the clamp ring 140, etc.). The second RF power supply 134 may be employed to apply a positive bias to the wafer pedestal 108 relative to the sputtering target 106 to further attract that portion of the sputtered target material which is ionized to the substrate 138 during copper deposition. Following deposition, the flow of gas to the high density plasma sputtering chamber 100 is halted, all biases (e.g., target, pedestal and coil) are terminated, and the substrate 138 is removed from the high density plasma sputtering chamber 100.

Unlike other metals, copper does not form a self-terminating oxide and readily oxidizes when exposed to oxygen. Accordingly, the wire coil 102, the sputtering target 106, the cups 126a-e and the pins 128a-e will readily oxidize when the sputtering target 106 is first installed within the high density plasma sputtering chamber 100, during preventative maintenance (e.g., during cleaning of the shield 124 and/or the clamp ring 140), and even during chamber idle due to the residual oxygen background. Any copper coating on the shield 124 and/or the clamp ring 140 also may oxidize during chamber idle. As previously stated, copper films formed from an oxidized copper target have poor surface roughness characteristics, high sheet resistance and high defect (e.g., splat) levels, and copper oxide layers formed on the wire coil 102, the sputtering target 106, any copper coating on the shield 124, the cups 126a-e, the pins 128a-e and any copper coating on the clamp ring 140 are highly porous and cause long pumpdown times and high base pressures.

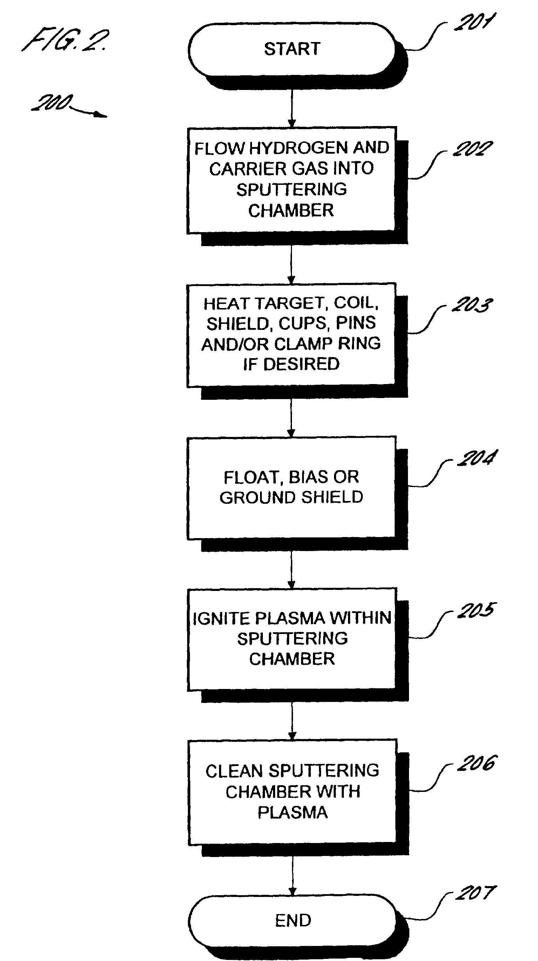

FIG. 2 is a flowchart of an inventive method for reducing the pump down time of a chamber configured for copper deposition ("inventive method 200"). As described below, the inventive method 200 effectively removes copper oxide from all chamber surfaces (e.g., the wire coil 102, the sputtering target 106, the shield 124 if copper coated, the cups 126a-e, the pins 128a-e, the clamp ring 140 if copper coated, etc.) of a chamber configured for copper deposition. Copper films deposited within a chamber, following performance of the inventive method 200 therein, exhibit improved surface roughness characteristics, lower sheet resistance and lower defect levels than copper films deposited within a deposition chamber cleaned by conventional methods. For convenience, the inventive method 200 is now described with reference to the high density plasma sputtering chamber 100 of FIG. 1 wherein the controller 136 is programmed to perform the inventive method 200 automatically. It will be understood that the inventive method 200 may be performed manually, if desired.

The inventive method 200 starts at Step 201. In Step 202, the controller 136 directs the gas source 118 to flow hydrogen and a carrier gas into the high density plasma sputtering chamber 100 from the hydrogen source 118a and from the carrier gas source 118b, respectively. A single source of hydrogen and carrier gas may be employed by diluting hydrogen within the carrier gas. Preferably, the ratio of cleaning gasses supplied to the high density plasma sputtering chamber 100 comprises about 5% or less hydrogen to 95% or more carrier gas. The preferred ratio is based purely on safety considerations. Higher hydrogen levels clean more effectively and may be employed if desired, although 5% hydrogen/95% carrier gas provides highly effective cleaning.

In Step 203, the wire coil 102, the sputtering target 106, the shield 124, the cups 126a-e, the pins 128a-e and/or the clamp ring 140 (optionally) are heated. Heating one or more of these components renders the cleaning reaction (described below) more thermodynamically favorable and therefore is preferred. Each of the chamber components may be heated by any known heating mechanism such as a heater tape, a heating jacket, heater rods or the like. Heating mechanisms already present within the high density plasma sputtering chamber 100 also may be employed to heat chamber components. For example, the bake-out lamps 130 may be used to heat the shield 124 directly and to heat the sputtering target 106 via conduction through the shield 124 and the water cooled adapter 110 by turning off the cooling system 112 during heating with the bake-out lamps 130. The wire coil 102, the cups 126a-e and the pins 128a-e may be heated directly by applying RF power to the wire coil 102 via the first RF power supply 104, as may the clamp ring 140 by applying power to the wafer pedestal 108's heater 109. The wire coil 102, the cups 126a-e and the pins 128a-e may be heated indirectly with the bake-out lamps 130 and with the wafer pedestal 108's heater via conduction through the shield 124 and through the cleaning gasses. Preferably the controller 136 is programmed to heat each of the wire coil 102, the sputtering target 106, the shield 124, the cups 126a-e, the pins 128a-e and the clamp ring 140 as described. In general, chemical activity, and thus cleaning effectiveness, increases with cleaning temperature.

In Step 204, the controller 136 directs the second DC power supply 133 to either bias the shield 124, ground the shield 124 or leave the shield 124 floating. It will be understood that Steps 203 and 204 may be performed in any order.

In Step 205, a plasma is ignited within the high density plasma sputtering chamber 100 containing the hydrogen and carrier gas mixture. The hydrogen/carrier gas plasma may be ignited by biasing the sputtering target 106 negatively with respect to the wafer pedestal 108 and the shield 124 as previously described, or a stand alone lid 142 (shown in phantom) which employs an inductively coupled RF antenna, may be used to generate the plasma as is know in the art (e.g., a dielectric cover that has a coil therein for inductively creating a plasma having radicalized gas atoms within the chamber 100 without sputtering the coil).

In Step 206, the hydrogen/carrier gas plasma is employed to clean copper oxide from a copper surface within the high density plasma sputtering chamber 100, including cleaning copper surfaces of the wire coil 102, the sputtering target 106, the shield 124, the cups 126a-e, the pins 128a-e and the clamp ring 140. Specifically, atomic hydrogen and/or hydrogen ions generated within the plasma react with copper oxide via the reactions:

$$CuO + 2H \rightarrow H_2O + Cu$$

$$CuO + 2H^+ + 2e^- \rightarrow H_2O + Cu.$$

The resultant $H_2O$ is pumped from the high density plasma sputtering chamber 100 via the exhaust pump 122 leaving the copper surfaces oxide free. Cleaning times vary depending on the plasma power, hydrogen concentration and the temperature of the various chamber components being cleaned.

Because copper oxidizes so readily, the inventive method 200 preferably is performed following each installation of a new copper target, following chamber maintenance or extended chamber idle periods and periodically (e.g., weekly) during normal chamber use. In this manner, copper films deposited within the high density plasma sputtering chamber 100 consistently exhibit superior surface roughness, sheet resistance and defect characteristics as compared to chambers cleaned employing conventional methods, and the high density plasma sputtering chamber 100 rapidly pumps down to a lower base pressure.

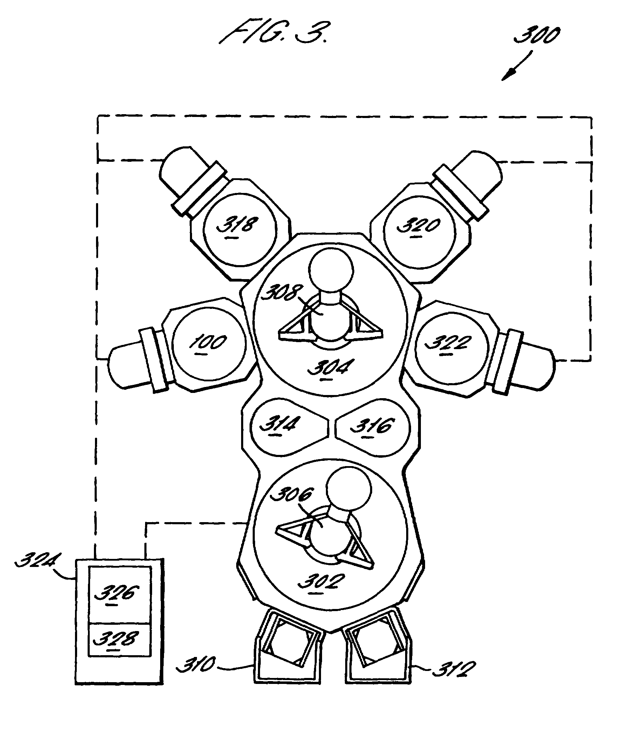

FIG. 3 is a top plan view of an automated semiconductor manufacturing tool 300 useful for performing the inventive method. Specifically, the automated semiconductor manufacturing tool 300 comprises a pair of chambers, a buffer chamber 302 and a transfer chamber 304 which house a first and a second wafer handler 306, 308, respectively. The buffer chamber 302 is coupled to a pair of load locks 310, 312 and to a pair of pass-through chambers 314 and 316. Other chambers such as degassing or cool-down chambers also may be coupled to the buffer chamber 302.

The transfer chamber 304 is coupled to the pass-through chambers 314, 316, and to a plurality of processing chambers 318, 320 and 322. Most importantly the transfer chamber 304 is coupled to the high density plasma sputtering chamber 100 of FIG. 1.

A controller 324 comprising a microprocessor 81 and a memory 328 is operatively coupled to the first and second wafer handlers 306, 308, to the load locks 310, 312, to the four processing chambers 100, 318 - 322, and to the various slit valves (not shown), for selectively sealing the load locks, pass-through chambers and processing chambers. The memory 328 contains a program for performing transfers between and processing within each of the processing chambers. The memory 328 also may be programmed to perform the inventive method on any of the processing chambers 100, 318 - 322. Note that because of the decrease in pump-down time for chambers in which the inventive method is performed, the overall productivity of the tool 300 is increased.

The foregoing description discloses only the preferred embodiments of the invention, modifications of the above disclosed apparatus and method which fall within the scope of the invention will be readily apparent to those of ordinary skill in the art. For instance, any non-reactive gas may be employed as the carrier gas, and any plasma or other vacuum chamber (e.g., copper deposition chambers, copper magnetron sputtering chambers, etc.) may benefit from the inventive method. Likewise, other plasma sources such as hollow cathode modules, electron cyclotron resonant sources, microwave sources, and coils exterior to the chamber or integral therewith may be employed.

Accordingly, while the present invention has been disclosed in connection with the preferred embodiments thereof, it should be understood that other embodiments may fall within the spirit and scope of the invention, as defined by the following claims.

## Claims

1. A method of reducing the pump down time of a chamber configured for copper deposition comprising:

   introducing hydrogen and a carrier gas into the chamber;
   igniting a plasma within the chamber; and
   cleaning the chamber with the plasma, including oxidized copper surfaces thereon.

2. The method of claim 1 wherein introducing hydrogen and a carrier gas into the chamber comprises introducing hydrogen and a carrier gas selected from the group consisting of argon, helium and nitrogen into the chamber.

3. The method of claim 1 wherein introducing hydrogen and a carrier gas into the chamber comprises introducing into the chamber hydrogen diluted to about 5% or less within the carrier gas.

4. The method of claim 1 further comprising heating a shield of the chamber during the step of cleaning the chamber with the plasma.

5. The method of claim 1 further comprising heating at least one of a copper target and a copper coil of the chamber.

6. The method of claim 1 wherein cleaning the chamber with the plasma comprises cleaning copper oxide from at least one of a copper target, a copper coil and a shield of the chamber.

7. The method of claim 1 wherein cleaning the chamber with the plasma comprises:

forming $H_2O$ via a reaction between the plasma and a copper oxide layer within the chamber; and

exhausting the $H_2O$ from the chamber.

8. A method of reducing the baseline vacuum of a chamber configured for copper deposition comprising:

performing chamber maintenance on the chamber; and

performing the method of claim 1 following performance of the chamber maintenance.

9. A method of depositing a copper film within a chamber configured for copper deposition:

performing the method of claim 1;

loading a semiconductor wafer into the chamber; and

depositing a copper film on the semiconductor wafer within the chamber.

10. A semiconductor device fabricated by the method of claim 9.

11. An apparatus comprising:

a deposition chamber configured for copper deposition;

a gas source coupled to the deposition chamber and comprising a source of hydrogen gas and a source of carrier gas; and

a controller coupled to both the deposition chamber and the gas source and having a program for:

introducing hydrogen and a carrier gas into the chamber from the gas source;

igniting a plasma within the chamber; and

cleaning the chamber with the plasma, including oxidized copper surfaces thereon.

12. The apparatus of claim 11 wherein the carrier gas comprises a gas selected from the group consisting of argon, helium and nitrogen.

13. The apparatus of claim 11 wherein the source of hydrogen gas and the source of carrier gas comprise a single source of both hydrogen and carrier gas.

14. The apparatus of claim 13 wherein the single source of hydrogen gas and carrier gas comprise as source of hydrogen diluted to about 5% or less within the carrier gas.

15. The apparatus of claim 11 wherein the chamber further comprises:

a shield; and

a heater coupled to the shield and to the controller and wherein the controller is programmed to heat the shield via the heater during the step of cleaning the chamber with the plasma.

16. The apparatus of claim 11 wherein the chamber further comprises:

a copper coil; and

an RF generator coupled to the copper coil and to the controller and wherein the controller is programmed to heat the copper coil via the RF generator during the step of cleaning the chamber with the plasma.

17. An automated semiconductor device fabrication tool comprising:

at least one load lock;

a wafer handler chamber coupled to the load lock, the wafer handler chamber having a wafer handler therein; and

a plurality of processing chambers coupled to the wafer handler and to the wafer handler chamber, wherein at least one of the plurality of processing chambers comprises the apparatus of claim 11.

FIG. 1.

FIG.2.

200

START — 201

FLOW HYDROGEN AND CARRIER GAS INTO SPUTTERING CHAMBER — 202

HEAT TARGET, COIL, SHIELD, CUPS, PINS AND/OR CLAMP RING IF DESIRED — 203

FLOAT, BIAS OR GROUND SHIELD — 204

IGNITE PLASMA WITHIN SPUTTERING CHAMBER — 205

CLEAN SPUTTERING CHAMBER WITH PLASMA — 206

END — 207

FIG. 3.